(19) Europäisches Patentamt
European Patent Office
Office européen des brevets

(11) **EP 3 379 570 A1**

(12) **EUROPÄISCHE PATENTANMELDUNG**

(43) Veröffentlichungstag:
**26.09.2018 Patentblatt 2018/39**

(51) Int Cl.:
*H01L 23/473* (2006.01)   *H01L 23/34* (2006.01)

(21) Anmeldenummer: **18162702.7**

(22) Anmeldetag: **20.03.2018**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(30) Priorität: **21.03.2017   DE 102017204732**

(71) Anmelder: **Siemens Aktiengesellschaft**
**80333 München (DE)**

(72) Erfinder:
• **Benkert, Katrin**
  **90571 Schwaig (DE)**
• **Holweg, Johann**
  **90513 Zirndorf (DE)**
• **Landes, Harald**
  **90607 Rückersdorf (DE)**

(54) **VERFAHREN ZUM BETREIBEN EINER KÜHLVORRICHTUNG**

(57)   Die Erfindung betrifft ein Verfahren zum Betreiben einer Kühlvorrichtung (2) einer elektronischen Schaltung wobei die Kühlvorrichtung (2) einen Kühlmittelkreislauf (6), der zur Kühlung mindestens eines Kühlkörpers (8, 9) vorgesehen ist, sowie einen Ionenaustauscher (10) umfasst, wobei der Ionenaustauscher (10) in einem Teilvolumenstrom (12) des Kühlmittelkreislaufs 6 angeordnet ist und der Teilvolumenstrom (12) durch den Ionenaustauscher (10) geleitet wird. Die Erfindung zeichnet sich dadurch aus, dass ein Gesamtvolumenstrom (14) so gesteuert wird, dass der Teilvolumenstrom (12) mehr als 10 % des Gesamtvolumenstroms (14) beträgt.

FIG 1

EP 3 379 570 A1

**Beschreibung**

Die Erfindung betrifft ein Verfahren zum Betreiben einer Kühlvorrichtung einer elektronischen Schaltung nach dem Oberbegriff des Patentanspruchs 1.

In HGÜ-Konverter-Stationen wird die Verlustleistung der eingesetzten Halbleiterbauelemente über von Reinstwasser durchströmte Kühldosen aus Aluminium abgeführt. Reinstwasser wird dazu zunächst nur deshalb eingesetzt, damit über die Kühlwasserleitungen, die aus Kunststoffrohren bestehen, auf Grund der hohen Anlagenspannung im 100 kV Bereich nicht hohe parasitäre Ströme fließen, die zu Teilentladungen und zur Korrosion von Metallteilen Anlass geben würden. Wird die Leitfähigkeit des Wassers auf Werte um 0,1 µS/cm begrenzt, so bleiben diese Ströme im mA oder µA Bereich und sind damit nicht Lebensdauer- begrenzend. Die Einstellung dieser Leitfähigkeit wird erreicht, indem man einen kleinen Bruchteil (0,1-1 %) des Kühlmittelstromes in Form eines Bypasses durch einen Ionenaustauscher leitet.

Eine Komplikation entsteht nun dadurch, dass Aluminium von Kühldosen durch das Kreislaufwasser in geringem Maße korrodiert wird. Die sich bildenden Hydroxide sind außerordentlich schlecht löslich. Die Hydroxide fallen unter Bildung von Kolloiden im Kühlwasser aus. Die Kolloide im sub µm-Bereich werden von der Strömung mitgerissen, reichern sich im Wasser an und lagern sich langsam an den dem Wasser zugewandten Oberflächen im Kreislauf als dünner Belag ab. Da die Kolloide Ionen inkorporiert haben bzw. Ionen anlagern sind sie selbst geladen. Zur Potentialsteuerung innerhalb des Kühlkreislaufes ragen an vielen Stellen Steuerelektroden z.B. in Form von Platinstiften in das Kühlwasser. Diese tragen das elektrische Potential der Schaltkomponenten und ihrer elektrischen Verbindungen in der unmittelbaren Umgebung der Kühlleitungen, um so elektrische Überschläge zwischen Kühlwasserleitungen und Schaltkomponenten zu verhindern. Diese Steuerelektroden saugen durch ihr Feld die geladenen bzw. sich im Feld polarisierenden Kolloide als auch die wenigen Al-haltigen Ionen aus dem Kühlwasserstrom. Dabei bilden sich auf den positiven (anodisch belasteten) Elektroden harte, spröde, keramische Beläge, die so dick werden, dass sie schließlich abplatzen, z. B. weil Gas, das sich durch Wasserspaltung unter den Belägen bildet und schlecht entweichen kann diese absprengt (der parasitäre Strom durch die Kühlleitungen wird überwiegend durch H+ - und OH- -Ionen getragen und nicht durch die weniger mobilen geladene Al-Verbindungen). Die abplatzenden Partikel haben Durchmesser im wenige mm-Bereich und neigen dazu, Engstellen im Kühlkreislauf zu verstopfen, so dass die zugehörigen Komponenten nur noch eingeschränkt gekühlt werden und schließlich durch Überhitzung ausfallen.

Die Aufgabe der Erfindung besteht darin, ein Verfahren zum Betreiben einer Kühlvorrichtung bereitzustellen, bei dem gegenüber dem Stand der Technik die Anlagerung von Belägen erheblich reduziert wird und somit die Wartungsintervalle der Kühlvorrichtung deutlich verlängert werden können.

Die Lösung der Aufgabe besteht in einem Verfahren zum Betreiben einer Kühlvorrichtung mit einer elektronischen Schaltung mit den Merkmalen des Patentanspruchs 1, sowie in einer Vorrichtung mit den Merkmalen des Patentanspruchs 8.

Das erfindungsgemäße Verfahren zum Betreiben einer Kühlvorrichtung mit einer elektronischen Schaltung umfasst dabei eine Kühlvorrichtung mit einem Kühlmittelkreislauf, der zur Kühlung mindestens eines Kühlkörpers vorgesehen ist. Ferner umfasst die Kühlvorrichtung einen Ionenaustauscher, wobei der Ionenaustauscher in einem Teilvolumenstrom des Kühlmittelkreislaufs angeordnet ist und wobei der Teilvolumenstrom durch den Ionenaustauscher geleitet wird. Die Erfindung zeichnet sich dadurch aus, dass ein Gesamtvolumenstrom so gesteuert wird, dass der Teilvolumenstrom mehr als 10 % des Gesamtvolumenstroms beträgt.

Es kann sowohl mathematisch als auch experimentell nachgewiesen werden, dass eine Erhöhung des Teilvolumenstromes um einen Faktor, der zwischen 10 und 100 liegt, eine deutliche Reduktion des Belages an sensiblen Bauteilen wie Steuerelektroden bewirkt. Üblicherweise beträgt der Volumenanteil des Teilvolumenstroms, der durch den Ionenaustauscher geleitet wird zwischen 0,1 und 1 %. Dieser Ionenaustausch wird gemäß des Standes der Technik lediglich dazu angewandt, um die Leitfähigkeit des Kühlmediums in einem vorgegebenen Bereich zu erhalten. Es ist durch diesen Ionenaustausch bislang nicht beabsichtigt worden, Kolloide und Ionen, die aus dem Materialabtrag im Wesentlichen von Aluminiumbauteilen, insbesondere Kühldosen stammen, aus dem Kühlmedium zu entfernen. Bisher herrscht die Meinung in der Fachwelt vor, dass eine Erhöhung des Teilvolumenstromes bzw. eine Erhöhung des Volumens, das dem Ionenaustauscher zugeführt wird, keine entscheidende Wirkung auf das Problem mit den Belägen auf sensiblen Bauteilen wie Steuerelektroden hat. Dieses Vorurteil kann inzwischen sowohl mathematisch als auch experimentell widerlegt werden. Die Erhöhung des Teilvolumenstroms, der durch den Ionenaustauscher geleitet wird, erfordert einen höheren apparatetechnischen Aufwand, da eine höhere Anzahl von einzelnen Ionenaustauscherelementen, beispielsweise in Form von Kartuschen in den Kreislauf eingefügt werden müssen. Ferner ist ein höherer Aufwand an Pumpleistung erforderlich. Auch aus diesem vermeintlichen Nachteil heraus ging die Fachwelt bisher davon aus, dass eine Erhöhung der Ionenaustauscherkapazität bzw. eine Erhöhung des Teilvolumenstroms, der durch den Ionenaustauscher fließt, lediglich negative Auswirkung insbesondere auf die Betriebskosten der Kühlvorrichtung hat. Nun hat sich aber durch mathematische Berechnung herausgestellt, dass die Intervalllänge zwischen Wartungsarbeiten an dem Kühlkreislauf durch die erfindungsgemäße Maßnahme soweit verlängert werden kann, dass die Mehrkosten, die durch eine höhere Ionenaustauscherkapazität erforderlich sind, um ein Mehrfaches wieder ausgeglichen werden.

Die beschriebene Kühlvorrichtung nach dem beschriebenen Verfahren ist zur Kühlung einer elektronischen Schaltung, insbesondere einer Leistungselektronikschaltung wiederum insbesondere einer Halbleiterleistungsschaltung geeignet. Insbesondere sind diese beschriebenen Leistungshalbleiterschaltungen zum Betreiben von Hochspannungsgleichstromübertragungsanlagen (HGÜ) geeignet. Insbesondere bei solchen HGÜ-Anlagen treten die beschriebenen Probleme auf, nämlich dass Steuerelektroden durch einen bestimmten Belag besetzt werden und somit eine Funktionsstörung der Kühlvorrichtung auftritt. Unter dem Begriff Kühlkörper wird ganz allgemein jegliche Vorrichtung verstanden, auf der insbesondere ein elektronisches Bauteil angeordnet ist und das zur Kühlung dieses Bauteils geeignet ist. Es gibt keramische Kühlkörper mit Kühlrippen, diese können metallisch beschichtet sein. Im Falle der Leistungshalbleiterschaltung werden als Kühlkörper vielfach sogenannte Kühldosen angewandt, die dazu dienen, die Betriebstemperatur elektronischer Bauteile zu reduzieren. Diese Kühldosen ermöglichen die direkte Wasserkühlung einer Wärmequelle wie etwa des genannten Halbleiterbauelementes oder eines Leistungswiderstandes. Die Kühldosen sind in der Regel aus Aluminium gefertigte Komponenten, die für sich genommen stromführend sind, womit sie gleichzeitig als Kühlung für den Halbleiter und zur Stromleitung dienen.

In einer weiteren Ausgestaltungsform ist der Teilvolumenstrom bezüglich des Gesamtvolumenstroms so ausgestaltet, dass er mehr als 20 %, bevorzugt mehr als 50 % des Gesamtvolumenstroms beträgt. Je nach Aufbau und Ausgestaltung der Kühlvorrichtung kann eine weitere Erhöhung des Teilvolumenstroms, der durch den Ionenaustauscher geleitet wird, zweckmäßig sein, um eine stärkere Reinigung des Kühlmediums von Aluminiumpartikeln und Ionen bzw. Partikeln aus Aluminiumverbindungen, zu erzielen. Grundsätzlich kann es auch zweckmäßig sein, den gesamten Volumenstrom durch einen Ionenaustauscher zu führen. Dies würde in der Diktion der vorhergehenden Ansprüche bedeuten, dass der Teilvolumenstrom gleich dem Gesamtvolumenstrom ist.

Der Ionenaustauscher bzw. der Teilvolumenstrom, in dem sich der Ionenaustauscher befindet, kann einerseits so angeordnet sein, dass er bezüglich eines Wärmetauschers zwischen diesem und den Kühlkörpern angeordnet ist. Dies ist zweckmäßig, wenn ein hoher Prozentsatz des Gesamtvolumenstromes durch den Ionenaustauscher geführt wird. Grundsätzlich ist es jedoch auch möglich, dass der Ionenaustauscher so angeordnet ist, dass der Teilvolumenstrom parallel zum Wärmetauscher verläuft.

Bevorzugt sind in dem Kühlkreislauf mindestens zwei Steuerelektroden angeordnet, die beispielsweise auf der Basis von Platin oder Platinlegierungen bzw. auf der Basis von Edelstahl ausgestaltet sein können. Diese Steuerelektroden dienen dazu, zwischen den einzelnen Kühlkörpern bzw. den einzelnen Kühldosen eine Potentialdifferenz zu minimieren oder das Wasser auf ein lokales Potential festzubinden.

Ein weiterer Bestandteil der Erfindung ist eine Vorrichtung zur Kühlung einer elektronischen Schaltung mit den Merkmalen des Patentanspruchs 8. Diese Vorrichtung weist dieselben, bereits bezüglich Anspruch 1 erörterten Vorteile auf.

Weitere Ausgestaltungsformen bzw. weitere Merkmale werden anhand der folgenden Figuren näher erläutert. Dabei handelt es sich um exemplarische Ausgestaltungsformen, die keine Einschränkung des Schutzbereiches darstellen. Dabei zeigen:

Figur 1     eine Kühlvorrichtung mit darin eingezeichneten Volumenströmen, wobei die Kühlvorrichtung einen Ionenaustauscher, einen Wärmetauscher und mehrere Kühldosen einer elektronischen Schaltung aufweist,

Figur 2     eine Kühlvorrichtung gemäß Figur 1, mit einer alternativen Schaltung des Teilvolumenstroms im Gesamtvolumenstrom.

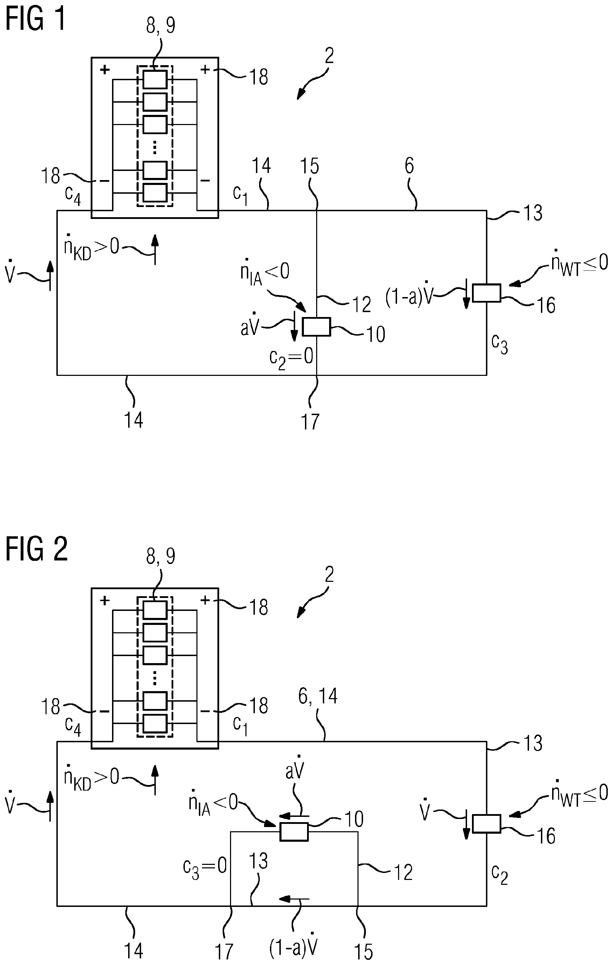

In Figur 1 ist eine Kühlvorrichtung 2 dargestellt, die einen Kühlkreislauf 6 umfasst, indem ein Kühlmedium zirkuliert, das hier nicht näher dargestellt ist. Bei dem Kühlmedium handelt es sich in der Regel um Wasser in bevorzugt sehr reiner Form. Der Kühlkreislauf 6 umfasst hierbei einen Gesamtvolumenstrom 14, von dem an einer Abzweigung 15 ein Teilvolumenstrom 12 abgezweigt wird. Der Teilvolumenstrom 12 wird im Weiteren durch einen Ionenaustauscher 10 geleitet und bei der Abzweigung 17 wieder in den Gesamtvolumenstrom 14 eingeleitet. Durch nicht dargestellte Pumpen und Drosselventile sind Vorkehrungen getroffen, dass die Volumenströme in den Zweigen 12, 13 und 14 in der in der Figur 1 angegebenen Größe fließen.. Ferner ist eine hier nicht dargestellte elektronische Schaltung vorhanden, die durch die Kühlvorrichtung 2 gekühlt wird. Die elektronische Schaltung, insbesondere eine Leistungshalbleiterschaltung ist auf Kühlkörpern 8, die hier in Form von Kühldosen 9 ausgestaltet sind, montiert. Die Kühldosen 9 in Figur 1 und 2 tragen somit Leistungselektronikbauteile, die in den Figuren nicht näher dargestellt sind. Durch die Kühldosen 9 wird der Kühlkreislauf bzw. der Kühlmittelkreislauf 6 geführt, wobei er sich beispielsweise dabei wieder in mehrere, nicht näher benannte Unterkreisläufe aufspaltet, die durch die einzelnen Kühldosen 9 verlaufen. Eine übliche Variante der Kühlwasserführung ist aber auch die serielle Verbindung der Kühldosen, die hier nicht gezeigt ist, auf die aber die Erfindung ebenfalls angewandt werden kann.

An charakteristischen Stellen der Kühlvorrichtung 2 im Bereich der elektronischen Schaltung bzw. im Bereich der Kühldosen 9 sind Steuerelektroden 18 angeordnet. Dabei sind die Steuerelektroden 18 in der Regel an endseitigen Bereichen von Feldern von Kühldosen 9 angeordnet. Die Steuerelektroden 18 dienen dazu, dem Kühlwasser das Potential der nächstliegenden elektrischen Leistungskomponenten bzw deren Kühlkörper aufzuprägen und damit korrosive Ströme von unedlen Metallen abzuhalten.

Ferner ist ein Wärmetauscher 16 vorgesehen, durch den die Wärmeenergie des Kühlmittels, die es beim Kühlen der Kühldosen 9 aufgenommen hat, wieder abgeführt wird.

Die bisher getroffenen Aussagen zu der Kühlvorrichtung 2 gemäß Figur 1 lassen sich auch auf die Kühlvorrichtung 2 gemäß Figur 2 anwenden. Die Kühlvorrichtungen 2 aus den Figuren 1 und 2 unterscheiden sich nun darin, wie der Teilvolumenstrom 12 bezüglich des Gesamtvolumenstroms 14 angeordnet ist. In Figur 1 verläuft der Teilvolumenstrom 12 parallel zu einem zweiten Teilvolumenstrom 13, in dem der Wärmetauscher 16 in Figur 1 angeordnet ist. Der Teilvolumenstrom 12 beträgt hierbei mindestens 10 % des Gesamtvolumenstroms 14. Der Teilvolumenstrom 12 und der zweite Teilvolumenstrom 13 ergeben in dieser Darstellung zusammen den Gesamtvolumenstrom 14. In vergleichbaren Anlagen nach dem Stand der Technik werden lediglich 0,1 bis 1 % des Gesamtvolumenstromes 14 in eine Ionenaustauschervorrichtung geleitet, durch eine Erhöhung dieses Volumenstroms in Form des Teilvolumenstromes 12 von mindestens 10 %, bevorzugt mehr als 20 % und besonders bevorzugt mehr als 50 % des Gesamtvolumenstroms 14 wird eine deutliche Reduktion von Aluminiumkolloiden und Ionen in dem Kühlmedium bewirkt. Dies führt wiederum dazu, dass sich gegenüber dem Stand der Technik die Ablagerungen auf den Steuerelektroden 18, die beispielsweise auf der Basis von Platin ausgestaltet sein können oder in Form von Edelstahlelektroden 18 ausgestaltet sein können, vermindert. Die Reduktion des Aluminiumanteils, worunter Kolloide und Ionen aus Aluminiumoxiden bzw. -hydroxiden oder anderen Aluminiumverbindungen verstanden werden, im Kühlmedium kann durch sukzessive Steigerung des Teilvolumenstroms 12 und die Bereitstellung einer entsprechend erhöhten Kapazität an Ionenaustauschern 10 bewerkstelligt werden. Dies führt wiederum dazu, dass die Belagsbildung auf den Steuerelektroden 18 so reduziert werden kann, dass im Idealfall über die gesamte Lebensdauer der Kühlmittelvorrichtung keine Reinigung der Steuerelektroden 18 vorgenommen werden muss. Grundsätzlich kann der Teilvolumenstrom 12 und die Ionenaustauscherkapazität sowie die Pumpleistung so gewählt werden, dass die Belagsbildung auf den Steuerelektroden so lange verlängert wird, bis eine geplante Routineüberholung der Kühlanlage stattfindet.

In Figur 2 ist eine Alternative zu Figur 1 bezüglich des Teilvolumenstroms 12 dargestellt. Hier ist der Teilvolumenstrom 12 hinter dem Wärmetauscher 16 und zwischen diesem und den Kühldosen 9 angeordnet. Hier läuft der Teilvolumenstrom 12 seriell zum Wärmetauscher 16 und parallel zum zweiten Teilvolumenstrom 13. Auch hier sind durch nicht dargestellte Pumpen und Drosselventile Vorkehrungen getroffen, die die beschriebenen Volumenströme gewährleisten.

Grundsätzlich kann es auch zweckmäßig sein, dass der Teilvolumenstrom 12 100 % des Gesamtvolumenstroms 14 beträgt. In diesem Sonderfall fallen dann der Teilvolumenstrom 12 und der Gesamtvolumenstrom 14 zusammen und der gesamte Kühlmittelkreislauf 6 wird durch den Ionenaustauscher 10 geführt. Ob dies erforderlich ist, hängt von der Art der Kühlvorrichtung und der installierten elektronischen Schaltung ab, ferner hängt dies auch von der Anzahl der Kühldosen und deren Korrosionsverschleiß ab. Ferner kann durch diese Maßnahme eine weitere Verlängerung der Intervallzeit zur Wartung der Steuerelektroden 18 erzielt werden. Somit hängt die Entscheidung, ob diese 100 % Gesamtvolumenstrom durch den Ionenaustauscher 10 geführt werden, insbesondere von wirtschaftlichen Erwägungen ab.

An der folgenden Beispielrechnung soll verdeutlicht werden, wie eine Veränderung des Teilvolumenstroms 12 sich auf die Bildung von Aluminium bzw. auf eine Aluminiumkonzentration im Kühlmedium auswirkt. Dabei seien folgende Größen definiert, die auch in den Figuren 1 und 2 dargestellt sind.

$\alpha$ : Teilvolumenstrom $\dot{V}_{IA}/\dot{V}$ (einige %)

$\dot{V}$ : Gesamtvolumenstrom (m$^3$/s)

$c_i$ : Al-Konzentration (mol/m$^3$) am Ort i

$\dot{n}_{XY}$ : Al-Eintragsrate (mol/s) durch Komponente XY. Sie ist > 0 bei Al-Abgabe an das Wasser im Fall der Kühldosen und < 0 bei Al-Aufnahme aus dem Kühlwasser im Fall der sich mit Kolloiden belegenden Flächen eines Wärmetauschers.

Daraus ergibt sich folgende mathematische Überlegung, die sich unmittelbar auf die in Fig. 1 dargestellte Schaltung bezieht:

$$c_1 = \frac{c_4 \dot{V} + \dot{n}_{KD}}{\dot{V}} = c_4 + \frac{\dot{n}_{KD}}{\dot{V}}$$

$$c_2 = 0 \quad !$$

$$c_3 = \frac{c_1(1-\alpha)\dot{V} + \dot{n}_{WT}}{(1-\alpha)\dot{V}} = c_1 + \frac{\dot{n}_{WT}}{(1-\alpha)\dot{V}}$$

$$c_4 = \frac{\alpha\dot{V}c_2 + (1-\alpha)\dot{V}c_3}{\dot{V}} = (1-\alpha)c_3 =$$

$$= (1-\alpha)\,c_1 + \frac{\dot{n}_{WT}}{\dot{V}} = (1-\alpha)\left(c_4 + \frac{\dot{n}_{KD}}{\dot{V}}\right) + \frac{\dot{n}_{WT}}{\dot{V}}$$

$$c_4 = \frac{(1-\alpha)\dot{n}_{KD} + \dot{n}_{WT}}{\alpha\dot{V}}$$

$$c_1 = c_4 + \frac{\dot{n}_{KD}}{\dot{V}} = \frac{(1-\alpha)\dot{n}_{KD} + \dot{n}_{WT}}{\alpha\dot{V}} + \frac{\dot{n}_{KD}}{\dot{V}} = \frac{\dot{n}_{KD} + \dot{n}_{WT}}{\alpha\dot{V}}$$

$$\dot{n}_{IA} = -\left(\dot{n}_{KD} + \dot{n}_{WT}\right)$$

$$\alpha \ll 1: \quad c_4 \approx c_1 \gg \frac{\dot{n}_{KD} + \dot{n}_{WT}}{\dot{V}} = -\frac{\dot{n}_{IA}}{\dot{V}}$$

Im Fall der Fig.2 findet man analog:

$$c_4 = \left(\frac{1}{\alpha} - 1\right)\frac{\dot{n}_{KD} + \dot{n}_{WT}}{\dot{V}}$$

$$c_1 = \frac{1}{\alpha}\frac{\dot{n}_{KD}}{\dot{V}} + \left(\frac{1}{\alpha} - 1\right)\frac{\dot{n}_{WT}}{\dot{V}}$$

$$\alpha \ll 1: \quad c_4 \approx c_1 = \frac{\dot{n}_{KD} + \dot{n}_{WT}}{\alpha\dot{V}} \gg -\frac{\dot{n}_{IA}}{\dot{V}}$$

Für beide Fälle gilt, dass bei einem niedrigen Teilvolumenstrom 12, bei dem $\alpha$ wesentlich kleiner als 1 ist, die in den Kühldosen 9 und im Wärmetauscher 12 umlaufende Aluminiumkonzentration um den Faktor $1/\alpha \gg 1$ größer ist, als die durch die Korrosion in der Kühldose 9 und im Wärmetauscher 16 effektiv eingespeiste Aluminiumsättigungskonzentration. Dann sind auch die Aluminiumkonzentrationen vor ($c_4$) und hinter ($c_1$) den Kühldosen 9 vergleichbar groß und entsprechendes ist für die Elektrodenniederschläge vor und hinter den Kühldosen zu erwarten. Die Aluminiumniederschlagsrate auf den Elektroden sollte ungefähr auf den Wert $1/\alpha$ sinken. Für die Annahme, dass $\alpha$ gegen 1 geht, sind stark verschiedene und stark herabgesetzte Aluminiumkonzentrationen und Niederschlagsraten zu erwarten.

Grundsätzlich kann gefolgert werden, dass unabhängig von der Schaltung des Ionenaustauschers 10 im Kühlmittelkreislauf 6 also gemäß der Figur 1 oder der Figur 2 davon ausgegangen werden kann, dass eine Erhöhung des Teilvolumenstroms, der gemäß des Standes der Technik bei 1 % liegt um einen Faktor 10 eine Reduktion der Aluminiumkonzentration um etwa den selben Faktor zu erzielen ist. Die lässt sich analog fortschreiben, sodass eine weitere Erhöhung des Teilvolumenstroms 10 um einen höheren Faktor, beispielsweise um einen Faktor 20, 50 oder gar um einen Faktor 100 eine vergleichbare Reduktion der Aluminiumkonzentration und somit der Ablagerungen auf sensiblen Bauteilen wie den Steuerelektroden 18 hervorruft.

**Patentansprüche**

1. Verfahren zum Betreiben einer Kühlvorrichtung (2) einer elektronischen Schaltung wobei die Kühlvorrichtung (2) einen Kühlmittelkreislauf (6), der zur Kühlung mindestens eines Kühlkörpers (8, 9) vorgesehen ist, sowie einen Ionenaustauscher (10) umfasst, wobei der Ionenaustauscher (10) in einem Teilvolumenstrom (12) des Kühlmittelkreislaufs (6) angeordnet ist und der Teilvolumenstrom (12) durch den Ionenaustauscher (10) geleitet wird, **dadurch gekennzeichnet, dass** ein Gesamtvolumenstrom (14) so gesteuert wird, dass der Teilvolumenstrom (12) mehr als 10 % des Gesamtvolumenstroms (14) beträgt.

2. Verfahren nach Anspruch 1, **dadurch gekennzeichnet, dass** der Teilvolumenstrom (12) mehr als 20 %, bevorzugt mehr als 50 % des Gesamtvolumenstroms (14) beträgt.

3. Verfahren nach Anspruch 1, **dadurch gekennzeichnet, dass** der Teilvolumenstrom (12) gleich dem Gesamtvolumenstrom (14) ist.

4. Verfahren nach einem der Ansprüche 1 bis 3, **dadurch gekennzeichnet, dass** der Ionenaustauscher (10) zwischen einem Wärmetauscher (16) und dem Kühlkörper (8, 9) angeordnet ist.

5. Verfahren nach einem der Ansprüche 1 oder 2, **dadurch gekennzeichnet, dass** der Teilvolumenstrom (12) parallel zu dem Wärmetauscher (16) verläuft.

6. Verfahren nach einem der vorhergehenden Ansprüche, **dadurch gekennzeichnet, dass** in dem Kühlmittelkreislauf (6) mindestens zwei Steuerelektroden (18) angeordnet sind.

7. Verfahren nach Anspruch 6, **dadurch gekennzeichnet, dass** die Steuerelektroden (18) auf der Basis von Platin, Platinlegierungen oder von Edelstahl ausgestaltet sind.

8. Vorrichtung zur Kühlung einer elektronischen Schaltung, umfassend einen Kühlmittelkreislauf (6) zur Kühlung mindestens eines Kühlkörpers (8, 9), sowie mindestens einen in einem für einen Teilvolumenstrom (12) vorgesehenen Leitungsabschnitt angeordneten Ionenaustauscher (10) und eine zur Förderung des Teilvolumenstrom (12) dienenden Fördervorrichtung, **dadurch gekennzeichnet, dass** der Ionenaustauscher (10) und die Fördervorrichtung so ausgelegt sind, dass ein Teilvolumenstrom (12) so einstellbar ist, dass er mindestens 10 % eines Gesamtvolumenstroms (14) umfasst

FIG 1

$\dot{n}_{KD} > 0$

$\dot{n}_{IA} < 0$

$\dot{n}_{WT} \leq 0$

$c_4$

$c_1$

$c_2 = 0$

$c_3$

$\dot{V}$

$a\dot{V}$

$(1-a)\dot{V}$

8, 9
18
2
14
15
6
13
18
12
10
16
14
17

FIG 2

$\dot{n}_{KD} > 0$

$\dot{n}_{IA} < 0$

$\dot{n}_{WT} \leq 0$

$c_4$

$c_1$

$c_3 = 0$

$c_2$

$\dot{V}$

$a\dot{V}$

$\dot{V}$

$(1-a)\dot{V}$

8, 9
18
2
18
18
6, 14
13
10
16
13
12
14
17
15

Europäisches
Patentamt

European
Patent Office

Office européen
des brevets

## EUROPÄISCHER RECHERCHENBERICHT

Nummer der Anmeldung

EP 18 16 2702

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X<br>Y<br>A | JP H11 89213 A (MITSUBISHI ELECTRIC CORP)<br>30. März 1999 (1999-03-30)<br>* Absätze [0021] - [0025]; Abbildung 1 * | 1-3,8<br>6,7<br>4,5 | INV.<br>H01L23/473<br>H01L23/34 |
| | ----- | | |
| Y<br><br>A | DE 10 2014 204241 A1 (SIEMENS AG [DE])<br>10. September 2015 (2015-09-10)<br>* Absätze [0026], [0027]; Abbildung 2 * | 6,7<br><br>1-5,8 | |
| | ----- | | |
| X<br><br>A | US 2 917 685 A (WIEGAND HENRY L)<br>15. Dezember 1959 (1959-12-15)<br>* das ganze Dokument * | 1-5,8<br><br>6,7 | |
| | ----- | | |

**RECHERCHIERTE SACHGEBIETE (IPC)**

H01L

Der vorliegende Recherchenbericht wurde für alle Patentansprüche erstellt

| Recherchenort | Abschlußdatum der Recherche | Prüfer |
|---|---|---|
| Den Haag | 13. Juli 2018 | Simeonov, Dobri |

KATEGORIE DER GENANNTEN DOKUMENTE

X : von besonderer Bedeutung allein betrachtet
Y : von besonderer Bedeutung in Verbindung mit einer
anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
nach dem Anmeldedatum veröffentlicht worden ist
D : in der Anmeldung angeführtes Dokument
L : aus anderen Gründen angeführtes Dokument

................................................................
& : Mitglied der gleichen Patentfamilie, übereinstimmendes
Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 18 16 2702

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

13-07-2018

| Im Recherchenbericht angeführtes Patentdokument | Datum der Veröffentlichung | Mitglied(er) der Patentfamilie | Datum der Veröffentlichung |
|---|---|---|---|
| JP H1189213 A | 30-03-1999 | JP 3296260 B2<br>JP H1189213 A | 24-06-2002<br>30-03-1999 |
| DE 102014204241 A1 | 10-09-2015 | KEINE | |
| US 2917685 A | 15-12-1959 | KEINE | |

EPO FORM P0461

Für nähere Einzelheiten zu diesem Anhang : siehe Amtsblatt des Europäischen Patentamts, Nr.12/82